# EUROPEAN PATENT SPECIFICATION

(11) **EP 3 332 432 B1**
(45) Date of publication and mention of the grant of the patent: **21.08.2019**
(21) Application number: 16738358.7
(22) Date of filing: 11.07.2016
(51) Int. Cl.: H01L 51/00, H01L 51/42

(54) **ORGANIC ELECTRONIC DEVICE AND THE PRODUCTION OF ORGANIC ELECTRONIC DEVICES**
ORGANISCHE ELEKTRONISCHE VORRICHTUNG UND DEREN HERSTELLUNG
DISPOSITIF ÉLECTRONIQUE ORGANIQUE ET SON PROCÉDÉ DE FABRICATION

(30) Priority: 06.08.2015 EP 15180015
(43) Date of publication of application: 13.06.2018
(73) Proprietor: Merck Patent GmbH, 64293 Darmstadt (DE)
(72) Inventor: CHEN, Lichun, Southampton SO15 2NY (GB); MALANDRAKI, Andromachi, 65474 Bischofsheim (DE)
(86) International application number: PCT/EP2016/001194
(87) International publication number: WO 2017/020988

(56) References cited:
- WO-A1-03/050147
- WO-A1-2010/131011
- THOMAS R. ANDERSEN ET AL: "Aqueous Processing of Low-Band-Gap Polymer Solar Cells Using Roll-to-Roll Methods", ACS NANO, vol. 5, no. 5, 24 May 2011 (2011-05-24), pages 4188-4196, XP055143769, ISSN: 1936-0851, DOI: 10.1021/nn200933r
- JEROEN STRYCKERS ET AL: "Eco-friendly spray coating of organic solar cells through water-based nanoparticles ink (Presentation Recording)", OPTICAL SENSING II, vol. 9561, 9 August 2015 (2015-08-09), page 95610B, XP055299532, 1000 20th St. Bellingham WA 98225-6705 USA ISSN: 0277-786X, DOI: 10.1117/12.2188420 ISBN: 978-1-62841-971-9

## Description

### Technical Field

The present application relates to compositions comprising an organic semiconducting material, a solvent, and specifically selected polymer particles, which allow modifying the viscosity of such compositions. The present application further relates to the use of such compositions in the production of organic electronic devices.

### Background and description of the prior art

Over the last decades organic semiconductors have attracted a lot of interest in academia as well as industry. Examples of major applications in which organic semiconductors have already been used are organic light emitting diodes (OLEDs), for example for displays and lighting, organic thin film transistors (OTFTs), for example for the backplane of displays, organic photovoltaic cells (OPVs) and organic photodiodes (OPDs), such as for example for optical sensors.

Organic semiconductors are characterized, for example, by being flexible and bendable as well as by the fact that they can be washed, thereby opening up new fields of application for semiconductor devices, such as for example "intelligent textiles".

While the deposition of inorganic semiconductors usually requires vacuum technologies, organic semiconductors can be applied by relatively simple and low-cost deposition and coating processes, including for example roll-to-roll ("R2R") processes and printing processes.

Inks and formulations to be applied by such printing processes generally require a viscosity of at least 50 cP. Adjustment of ink viscosity is complicated by the fact that it depends upon a number of variables, such as the nature of the ink components, for example the molecular weight of the organic semiconducting compound or the nature of the solvent, as well as the respective concentrations of the components. Furthermore, organic semiconducting compounds are frequently designed for maximizing their electronic properties, such as for example charge carrier mobility without regards to solubility, thus limiting the choice of potential solvents.

It has been attempted to increase ink viscosity using additives. However, frequently the addition of solid additives led to a decrease in the electrical properties of an organic semiconducting layer deposited from such an ink.

WO 2010/131011 A1 discloses a process for the production of a semiconductor thin film structure, in which nanoparticles of a removable material, such as polystyrene, are co-deposited with a first semiconductor material on a substrate, by self-assembly form a structure defining a network of interstitial spaces, which are infiltrated by a first semiconductor material, and the nanoparticles are then removed so as to leave a three dimensional structure of the first semiconductor material including a network of interconnected pores.

T.R. Andersen et al., ACS Nano, vol. 5, no. 5, 4188-4196, 2011 disclose the formation of films for solar cells by roll-to-roll slot-die and screen printing methods using aqueous dispersions of nanoparticles of a series of three low-band-gap polymers and [6,6]-phenyl-C₆₁-butyric acid methyl ester.

WO 03/050147 A1 discloses a method for producing nanoparticles of organic semiconductors by mixing an aqueous or alcoholic phase that comprises a surfactant and an organic phases that comprises one or more conjugated polymers in liquid form, producing a micro- or mini-emulsion, and producing an aqueous dispersion.

It is therefore one of the objects of the present application to provide for a method whereby the viscosity of an ink or formulation comprising an organic semiconducting compound may be increased without the drawbacks of the known methods.

It is also an object of the present application to provide such an ink or formulation.

Further, it is an object of the present application to provide a method for producing an organic electronic device wherein an ink or formulation comprising a semiconducting compound may be deposited on a support.

### Summary of the invention

The present inventors have now surprisingly found that the above objects may be attained either individually or in any combination by the device and process of the present application.

The present application therefore provides for a device comprising a layer that in turn comprises an organic semiconducting material and a polymer in form of particles, wherein said particles have a diameter of at most 2 µm, wherein the device is and organic photovoltaic device or an organic photodetector device, and wherein the polymer is polystyrene.

In addition the present application provides for a process of preparing such a device, said process comprising the steps of
(a) providing a composition comprising an organic semiconducting material, a solvent and a polymer in form of particles,
(b) depositing said composition onto a substrate, and
(c) essentially removing said solvent,
wherein said particles have a diameter of at most 2 µm, and said device is an organic photovoltaic device or an organic photodetector device.

Furthermore, the present application provides for the use of a polymer in form of particles to adapt the viscosity of a composition comprising an organic semiconductor material and a solvent, wherein said particles have a diameter of at most 2 µm.

### Brief description of the figures

**Figure 1** shows the IV curves of the organic photodetector devices of Example 3 prepared with formulations S2 and S3.
**Figure 2** shows the external quantum efficiency (EQE) of organic photodetector devices of Example 3 prepared with formulations S5, S6, S7 and S8.
**Figure 3a** shows the IV curves of the organic photodetector device of Example 3 prepared with formulation S2 at 0 days, 14 days and 35 days from producing the devices.
**Figure 3b** shows the IV curves of the organic photodetector device of Example 3 prepared with formulation S3 at 0 days, 14 days and 35 days from producing the devices.

### Detailed description of the invention

For the purposes of the present application the terms "ink" and "formulation" are used to denote a composition comprising an organic semiconducting material and a solvent.

For the purposes of the present application the term "organic semiconducting material" is used to denote a semiconducting material comprising at least one organic semiconducting compound. Hence, such organic semiconducting material may also comprise one or more inorganic semiconducting compound.

As used herein, unless stated otherwise the molecular weight is given as the number average molecular weight Mₙ or weight average molecular weight M_{w}, which is determined by gel permeation chromatography (GPC) against polystyrene standards in eluent solvents such as tetrahydrofuran, trichloromethane (TCM, chloroform), chlorobenzene or 1,2,4-trichlorobenzene. Unless stated otherwise, chlorobenzene is used as solvent. The molecular weight distribution ("MWD"), which may also be referred to as polydispersity index ("PDI"), of a polymer is defined as the ratio M_{w}/Mₙ. The degree of polymerization, also referred to as total number of repeat units, m, will be understood to mean the number average degree of polymerization given as m = Mₙ/M_{U}, wherein Mₙ is the number average molecular weight of the polymer and M_{U} is the molecular weight of the single repeat unit; see J.M.G. Cowie, Polymers: Chemistry & Physics of Modern Materials, Blackie, Glasgow, 1991.

In general terms the composition of the present application comprises
(i) an organic semiconducting material,
(ii) a solvent, and
(iii) polymer particles.

### ORGANIC SEMICONDUCTING MATERIAL

The organic semiconducting material comprised in the present composition is not particularly limited, provided that it comprises at least one organic semiconducting compound. The present organic semiconducting material may for example comprise one or more organic semiconducting compound in at least 50 wt% or 60 wt% or 70 wt% or 80 wt% or 90 wt% or 95 wt% or 97 wt% or 99 wt% or 99.5 wt%, relative to the total weight of the organic semiconducting material, and may preferably consist of one or more organic semiconducting compounds. The present organic semiconducting material may, for example, comprise one or more organic p-type semiconducting compound or one or more n-type semiconducting compound or both, one or more organic p-type semiconducting compound and one or more n-type semiconducting compound. The one or more semiconducting compound, preferably the one or more organic p-type semiconducting compound, may for example also be one or more photoactive compound. The term "photoactive compound" is used to denote a compound that aids in converting incoming light into electrical energy.

The one or more organic p-type semiconducting compound may, for example, be a polymer, an oligomer or a small molecule, and may, for example, be represented by the following formula (I)

-[M-]ₘ- (I)

wherein M is as defined in the following and, for the purposes of the present application, m is 1 for a small molecule, from 2 to 10 for an oligomer and at least 11 for a polymer.

The one or more organic p-type semiconducting compound suitable for use in the present application is not particularly limited. Such organic p-type semiconducting compounds are generally well known to the skilled person.

Examples of suitable organic p-type semiconducting compounds include any conjugated aryl and heteroaryl compounds, optionally further comprising one or more ethene-2,1-diyl (*-(R¹)C=C(R²)-*) and ethyndiyl (*-C≡C-*), with R¹ and R² being as defined herein.

R¹ and R² are carbyl groups, preferably selected from the group consisting of alkyl having from 1 to 20 carbon atoms, partially or completely fluorinated alkyl having from 1 to 20 carbon atoms, phenyl and phenyl substituted with alkyl having from 1 to 20 carbon atoms or partially or completely fluorinated alkyl having from 1 to 20 carbon atoms.

Exemplary organic p-type semiconducting compounds may be conjugated aryl and heteroaryl compounds, for example an aromatic compound, containing preferably two or more, very preferably at least three aromatic rings. Preferred examples of organic p-type semiconducting compounds contain aromatic rings selected from 5-, 6- or 7-membered aromatic rings, more preferably selected from 5- or 6-membered aromatic rings.

Each of the aromatic rings of the organic p-type semiconducting compound may optionally contain one or more hetero atoms selected from Se, Te, P, Si, B, As, N, O or S, generally from N, O or S.

Further, the aromatic rings may be optionally substituted with alkyl, alkoxy, polyalkoxy, thioalkyl, acyl, aryl or substituted aryl groups, halogen, where fluorine, cyano, nitro or an optionally substituted secondary or tertiary alkylamine or arylamine represented by -N(R³)(R⁴), where R³ and R⁴ are each independently H, an optionally substituted alkyl or an optionally substituted aryl, alkoxy or polyalkoxy groups are typically employed. Further, where R³ and R⁴ is alkyl or aryl these may be optionally fluorinated.

The aforementioned aromatic rings can be fused rings or linked with a conjugated linking group such as -C(T₁)=C(T₂)-, -C≡C-, -N(R"')-, -N=N-, (R"')=N-, -N=C(R"')-, where T₁ and T₂ each independently represent H, CI, F, -C≡N or lower alkyl groups such as alkyl groups having from 1 to 4 carbon atoms; R'" represents H, optionally substituted alkyl or optionally substituted aryl. Further, where R'" is alkyl or aryl it can be fluorinated.

Preferred examples of organic p-type semiconducting compounds suitable for the purposes of the present application include compounds, oligomers and derivatives of compounds selected from the group consisting of conjugated hydrocarbon polymers such as polyacene, polyphenylene, poly(phenylene vinylene), polyfluorene including oligomers of those conjugated hydrocarbon polymers; condensed aromatic hydrocarbons, such as, tetracene, chrysene, pentacene, pyrene, perylene, coronene, or soluble, substituted derivatives of these; oligomeric para substituted phenylenes such as p-quaterphenyl (p-4P), p-quinquephenyl (p-5P), p-sexiphenyl (p-6P), or soluble substituted derivatives of these; conjugated heterocyclic polymers such as poly(3-substituted thiophene), poly(3,4-bisubstituted thiophene), optionally substituted polythieno[2,3-b]thiophene, optionally substituted polythieno[3,2-b]thiophene, poly(3-substituted selenophene), polybenzothiophene, polyisothianapthene, poly(*N-*substituted pyrrole), poly(3-substituted pyrrole), poly(3,4-bisubstituted pyrrole), polyfuran, polypyridine, poly-1,3,4-oxadiazoles, polyisothianaphthene, poly(*N*-substituted aniline), poly(2-substituted aniline), poly(3-substituted aniline), poly(2,3-bisubstituted aniline), polyazulene, polypyrene; pyrazoline compounds; polyselenophene; polybenzofuran; polyindole; polypyridazine; benzidine compounds; stilbene compounds; triazines; substituted metallo- or metal-free porphines, phthalocyanines, fluorophthalocyanines, naphthalocyanines or fluoronaphthalocyanines; *N,N'*-dialkyl, substituted dialkyl, diaryl or substituted diaryl-1,4,5,8-naphthalenetetracarboxylic diimide and fluoro derivatives; *N,N'-*dialkyl, substituted dialkyl, diaryl or substituted diaryl 3,4,9,10-perylenetetracarboxylicdiimide; bathophenanthroline; diphenoquinones; 1,3,4-oxadiazoles; 11,11,12,12-tetracyanonaptho-2,6-quinodimethane; α,α'-bis(di-thieno[3,2-b-2',3'-d]thiophene); 2,8-dialkyl, substituted dialkyl, diaryl or substituted diaryl anthradithiophene; 2,2'-bisbenzo[1,2-b:4,5-b']dithiophene.

Further, in some preferred embodiments in accordance with the present invention, the organic p-type semiconducting compounds are polymers or copolymers that encompass one or more repeating units selected from thiophene-2,5-diyl, 3-substituted thiophene-2,5-diyl, optionally substituted thieno[2,3-b]thiophene-2,5-diyl, optionally substituted thieno[3,2-b]thiophene-2,5-diyl, selenophene-2,5-diyl, or 3-substituted selenophene-2,5-diyl.

Further preferred examples of organic p-type semiconducting compounds are copolymers comprising one or more electron acceptor unit and one or more electron donor unit. Preferred copolymers of this preferred embodiment are for example copolymers comprising one or more benzo[1,2-b:4,5-b']dithiophene-2,5-diyl units that are preferably 4,8-disubstituted, and further comprising one or more aryl or heteroaryl units selected from Group A and Group B, preferably comprising at least one unit of Group A and at least one unit of Group B, wherein Group A consists of aryl or heteroaryl groups having electron donor properties and Group B consists of aryl or heteroaryl groups having electron acceptor properties.

Group A consists of selenophene-2,5-diyl, thiophene-2,5-diyl, thieno[3,2-b]thiophene-2,5-diyl, thieno[2,3-b]thiophene-2,5-diyl, selenopheno[3,2-b]selenophene-2,5-diyl, selenopheno[2,3-b]selenophene-2,5-diyl, selenopheno [3,2-b]thiophene-2,5-diyl, selenopheno[2,3-b]thiophene-2,5-diyl, benzo[1,2-b:4,5-b']dithiophene-2,6-diyl, 2,2-dithiophene, 2,2-diselenophene, dithieno[3,2-b:2',3'-*d*]silole-5,5-diyl, 4*H*-cyclopenta[2,1-*b*:3,4-*b*']dithiophene-2,6-diyl, 2,7-di-thien-2-yl-carbazole, 2,7-di-thien-2-yl-fluorene, indaceno[1,2-b:5,6-b']dithiophene-2,7-diyl, benzo[1",2":4,5;4",5":4',5']bis(silolo[3,2-b:3',2'-b']thiophene)-2,7-diyl, 2,7-di-thien-2-yl-indaceno[1,2-b:5,6-b']dithiophene, 2,7-di-thien-2-yl-benzo[1",2":4,5;4", 5":4',5']bis(silolo[3,2-b:3',2'-b']thiophene)-2,7-diyl, and 2,7-di-thien-2-yl-phenanthro[1,10,9,8-*c,d,e,j,g*]carbazole, all of which are optionally substituted by one or more, preferably one or two groups R¹ as defined above, and

Group B consists of benzo[2,1,3]thiadiazole-4,7-diyl, 5,6-dialkyl-benzo[2,1,3]thiadiazole-4,7-diyl, 5,6-dialkoxybenzo[2,1,3]thiadiazole-4,7-diyl, benzo[2,1,3]selenadiazole-4,7-diyl, 5,6-dialkoxy-benzo[2,1,3]selenadiazole-4,7-diyl, benzo[1,2,5]thiadiazole-4,7,diyl, benzo[1,2,5]selenadiazole-4,7,diyl, benzo[2,1,3]oxadiazole-4,7-diyl, 5,6-dialkoxybenzo[2,1,3]oxadiazole-4,7-diyl, 2H-benzotriazole-4,7-diyl, 2,3-dicyano-1,4-phenylene, 2,5-dicyano,1,4-phenylene, 2,3-difluro-1,4-phenylene, 2,5-difluoro-1,4-phenylene, 2,3,5,6-tetrafluoro-1,4-phenylene, 3,4-difluorothiophene-2,5-diyl, thieno[3,4-b]pyrazine-2,5-diyl, quinoxaline-5,8-diyl, thieno[3,4-b]thiophene-4,6-diyl, thieno[3,4-b]thiophene-6,4-diyl, and 3,6- pyrrolo[3,4-c]pyrrole-1,4-dione, all of which are optionally substituted by one or more, preferably one or two groups R¹ as defined above.

In other preferred embodiments of the present invention, the organic p-type semiconducting compounds are substituted oligoacenes. Examples of such oligoacenes may, for example, be selected from the group consisting of pentacene, tetracene or anthracene, and heterocyclic derivatives thereof. Bis(trialkylsilylethynyl) oligoacenes or bis(trialkylsilylethynyl) heteroacenes, as disclosed for example in US 6,690,029 or WO 2005/055248 A1 or US 7,385,221, are also useful.

The one or more n-type semiconducting compound is not particularly limited. Examples of suitable n-type semiconducting compounds are well known to the skilled person and include inorganic compounds and organic compounds.

The n-type semiconducting compound may for example be an inorganic semiconducting compound selected from the group consisting of zinc oxide (ZnOₓ), zinc tin oxide (ZTO), titanium oxide (TiOₓ), molybdenum oxide (MoOₓ), nickel oxide (NiOₓ), cadmium selenide (CdSe) and any blend of these.

The n-type semiconducting compound may, for example, be an organic compound selected from the group consisting of graphene, fullerene, substituted fullerene and any blends of these.

Examples of suitable fullerenes and substituted fullerenes may, for example, be selected from the group consisting of indene-C₆₀-fullerene bis-adduct like ICBA, or a (6,6)-phenyl-butyric acid methyl ester derivatized methano C₆₀ fullerene, also known as "PCBM-C₆₀" or "C₆₀PCBM", as disclosed for example in G. Yu, J. Gao, J.C. Hummelen, F. Wudl, A.J. Heeger, Science 1995, Vol. 270, p. 1789 ff and having the structure shown below, or structural analogous compounds with e.g. a C₆₁ fullerene group, a C₇₀ fullerene group, or a C₇₁ fullerene group, or an organic polymer (see for example Coakley, K. M. and McGehee, M. D. Chem. Mater. 2004, 16, 4533).

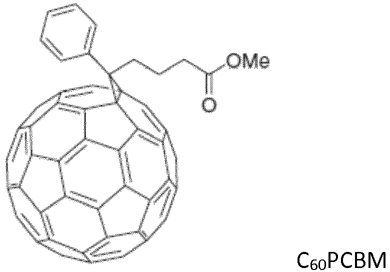

Preferably, the organic p-type semiconducting compound is blended with an n-type semiconductor such as a fullerene or substituted fullerene, like for example PCBM-C₆₀, PCBM-C₇₀, PCBM-C₆₁, PCBM-C₇₁, bis-PCBM-C₆₁, bis-PCBM-C₇₁, ICMA-c₆₀ (1',4'-Dihydro-naphtho[2',3':1,2][5,6]fullerene-C₆₀), ICBA-C₆₀, oQDM-C₆₀ (1',4'-dihydro-naphtho[2',3':1,9][5,6]fullerene-C60-lh), bis-oQDM-C₆₀, graphene, or a metal oxide, like for example, ZnOₓ, TiOₓ, ZTO, MoOₓ, NiOₓ, or quantum dots like for example CdSe or CdS, to form the active layer in an OPV or OPD device.

### SOLVENT

The solvent comprised in the composition of the present application is not particularly limited. It may, for example, be water or one or more non-aqueous solvents or a mixture of water and one or more non-aqueous solvents. Preferably, the solvent is an organic solvent or a mixture of two or more organic solvents.

Preferred examples of organic solvents suitable for the purposes of present application may be selected from the list comprising aliphatic hydrocarbons, chlorinated hydrocarbons, aromatic hydrocarbons, ketones, ethers and mixtures thereof. Additional solvents which can be used include 1,2,4-trimethylbenzene, 1,2,3,4-tetra-methyl benzene, pentylbenzene, mesitylene, cumene, cymene, cyclohexylbenzene, diethylbenzene, tetralin, decalin, 2,6-lutidine, 2-fluoro-m-xylene, 3-fluoro-o-xylene, 2-chlorobenzotrifluoride, N,N-dimethylformamide, 2-chloro-6-fluorotoluene, 2-fluoroanisole, anisole, 2,3-dimethylpyrazine, 4-fluoroanisole, 3-fluoroanisole, 3-trifluoro-methylanisole, 2-methylanisole, phenetol, 4-methylanisole, 3-methylanisole, 4-fluoro-3-methylanisole, 2-fluorobenzonitrile, 4-fluoroveratrol, 2,6-dimethylanisole, 3-fluorobenzo-nitrile, 2,5-dimethylanisole, 2,4-dimethylanisole, benzonitrile, 3,5-dimethyl-anisole, N,N-dimethylaniline, ethyl benzoate, 1-fluoro-3,5-dimethoxy-benzene, 1-methylnaphthalene, N-methylpyrrolidinone, 3-fluorobenzo-trifluoride, benzotrifluoride, dioxane, trifluoromethoxy-benzene, 4-fluorobenzotrifluoride, 3-fluoropyridine, toluene, 2-fluoro-toluene, 2-fluorobenzotrifluoride, 3-fluorotoluene, 4-isopropylbiphenyl, phenyl ether, pyridine, 4-fluorotoluene, 2,5-difluorotoluene, 1-chloro-2,4-difluorobenzene, 2-fluoropyridine, 3-chlorofluorobenzene, 1-chloro-2,5-difluorobenzene, 4-chlorofluorobenzene, chloro-benzene, o-dichlorobenzene, 2-chlorofluorobenzene, p-xylene, m-xylene, o-xylene or mixture of o-, m-, and p-isomers. Solvents with relatively low polarity are generally preferred. For inkjet printing solvents and solvent mixtures with high boiling temperatures are preferred. For spin coating alkylated benzenes like xylene and toluene are preferred.

Examples of especially preferred solvents include, without limitation, dichloromethane, trichloromethane, chlorobenzene, o-dichlorobenzene, tetrahydrofuran, anisole, morpholine, toluene, o-xylene, m-xylene, p-xylene, 1,4-dioxane, acetone, methylethylketone, 1,2-dichloroethane, 1,1,1-trichloroethane, 1,1,2,2-tetrachloroethane, 3,5-dimethyl anisole , ethyl acetate, n-butyl acetate, N,N-dimethylformamide, dimethylacetamide, dimethylsulfoxide, tetraline, decaline, indane, methyl benzoate, ethyl benzoate, mesitylene and/or mixtures thereof.

### POLYMER PARTICLES

The present composition comprises polymer particles, wherein said polymer particles have a diameter of at most 2 µm. Preferably said polymer particles have a diameter of at most 1.5 µm, more preferably of at most 1.0 µm or 0.9 µm or 0.8 µm or 0.7 µm or 0.6 µm, and most preferably of at most 0.5 µm. Preferably, said polymer particles have a diameter of at least 10 nm, more preferably of at least 15 nm and most preferably of at least 20 nm.

Preferably, said polymer particles comprise a polymer which comprises cross-linking, i.e. a polymer with a certain degree of cross-linking.

The type of polymer comprised in the polymer particles is not particularly limited as long as it forms a stable dispersion and is selected from polystyrene. For the purposes of the present application the term "stable dispersion of polymer particles" is to denote a dispersion of polymer particles in the one or more solvent as defined above, wherein said polymer particles remain dispersed for at least 24 hours, preferably for at least 48 hours after having been dispersed in the one or more solvent.

The present polymer particles preferably comprise a cross-linkable polymer in at least 50 wt% or 60 wt% or 70 wt% or 80 wt%% or 90 wt% or 95 wt% or 97 wt% or 99 wt%, relative to the total weight of said polymer particles, or most preferably consist of such cross-linkable polymer.

The cross-linkable polymer used in the present application is polystyrene.

Cross-linkable or already cross-linked polymers are generally known to the skilled person and may be obtained from commercial sources, such as for example from Spherotech Inc., Lake Forest, Illinois, USA or from Sigma-Aldrich.

Preferably, the polymer comprised in said polymer particles has a number average molecular weight Mₙ (as determined, for example, by GPC) of at least 50,000 g/mol, more preferably of at least 100,000 g/mol, even more preferably of at least 150,000 g/mol, and most preferably of at least 200,000 g/mol. Preferably, the polymer comprised in said polymer particles has a number average molecular weight Mₙ (as determined, for example, by GPC) of at most 2,000,000 g/mol, more preferably of at most 1,500,000 g/mol and most preferably of at most 1,000,000 g/mol.

For crosslinking, the polymer is exposed to an electron beam or to electromagnetic (actinic) radiation such as X-ray, UV or visible radiation, or heated if it contains thermally crosslinkable groups. For example, actinic radiation may be employed at a wavelength of from 11 nm to 700 nm, such as from 200 to 700 nm. A dose of actinic radiation for exposure is generally from 25 to 15000 mJ/cm². Suitable radiation sources include mercury, mercury/xenon, mercury/halogen and xenon lamps, argon or xenon laser sources, x-ray. Such exposure to actinic radiation is to cause crosslinking in exposed regions. An example of a crosslinkable group is a maleimide pendant group. If it is desired to use a light source having a wavelength outside of the photo-absorption band of the maleimide group, a radiation sensitive photosensitizer can be added. If the polymer contains thermally crosslinkable groups, optionally an initiator may be added to initiate the crosslinking reaction, for example in case the crosslinking reaction is not initiated thermally. Exemplary conditions for crosslinking are UV irradiation with a wavelength of 365 nm at a dose of 88 mJ.

In another preferred embodiment, the crosslinkable polymer composition comprises a stabilizer material or moiety to prevent spontaneous crosslinking and improve shelf life of the polymer composition. Suitable stabilizers are antioxidants such as catechol or phenol derivatives that optionally contain one or more bulky alkyl groups, for example t-butyl groups, in ortho-position to the phenolic OH group.

Crosslinking by exposure to UV radiation is preferred.

The crosslinkable group of the crosslinker is preferably selected from a maleimide, a 3-monoalkyl-maleimide, a 3,4-dialkylmaleimide, an epoxy, a vinyl, an acetylene, an indenyl, a cinnamate or a coumarin group, or a group that comprises a substituted or unsubstituted maleimide portion, an epoxide portion, a vinyl portion, an acetylene portion, an indenyl portion, a cinnamate portion or a coumarin portion.

Very preferably the crosslinker is selected of formula (11-1) or (11-2)

P-A"-X'-A"-P (II-1)

H_{4-c}C(A"-P)_{c} (II-2)

wherein X' is O, S, NH or a single bond, A" is a single bond or a connecting, spacer or bridging group, which is selected from (CZ₂)ₙ, (CH₂)ₙ-(CH=CH)ₚ-(CH₂)ₙ, (CH₂)ₙ-O-(CH₂)ₙ, (CH₂)ₙ-C₆Q₁₀-(CH₂)ₙ, and C(O), where each n is independently an integer from 0 to 12, p is an integer from 1 to 6 (for example 1, 2, 3, 4, 5 or 6), Z is independently H or F, C₆Q₁₀ is cyclohexyl that is substituted with Q, Q is independently H, F, CH₃, CF₃, or OCH₃, P is a crosslinkable group, and c is 2, 3, or 4, and where in formula (II-1) at least one of X' and the two groups A" is not a single bond.

P is preferably selected from a maleimide, a 3-monoalkyl-maleimide, a 3,4-dialkylmaleimide, an epoxy, a vinyl, an acetylene, an indenyl, a cinnamate or a coumarin group, or comprises a substituted or unsubstituted maleimide portion, an epoxide portion, a vinyl portion, an acetylene portion, an indenyl portion, a cinnamate portion or a coumarin portion.

Preferably, the present polymer particles are not soluble in the solvents comprised in the present composition.

### Devices and Device Preparation

In general terms the present application also relates to a device comprising a layer that in turn comprises an organic semiconducting material and polymer particles as defined above.

The present application further relates to a process of preparing such a device as defined above, said process comprising the steps of
(a) providing a composition comprising an organic semiconducting material, a solvent and polymer particles,
(b) depositing said composition onto a substrate and
(c) essentially removing said solvent.

Preferably, step (b) of the present process is performed by screen printing, gravure printing or flexographic printing.

For the purposes of the present application the term "essentially removing said solvent" is used to denote that at least 50 wt%, preferably at least 60 wt% or 70 wt%, more preferably at least 80 wt% or 90 wt%, even more preferably at least 92 wt% or 94 wt% or 96 wt% or 98 wt%, still even more preferably at least 99 wt%, and most preferably at least 99,5 wt% of the solvent are removed, with wt% being relative to the weight of the solvent in the composition provided in step (a).

The compounds and polymers according to the present invention can also be used in patterned OSC layers in the devices as described above and below. For applications in modern microelectronics it is generally desirable to generate small structures or patterns to reduce cost (more devices/unit area) and power consumption. Patterning of thin layers comprising a polymer according to the present invention can be carried out for example by photolithography, electron beam lithography or laser patterning.

For use as thin layers in electronic or electrooptical devices the compounds, polymers, polymer blends or formulations of the present invention may be deposited by any suitable method. Liquid coating of devices is more desirable than vacuum deposition techniques. Solution deposition methods are especially preferred. The formulations of the present invention enable the use of a number of liquid coating techniques. Preferred deposition techniques include, without limitation, dip coating, spin coating, ink jet printing, nozzle printing, letter-press printing, screen printing, gravure printing, doctor blade coating, roller printing, reverse-roller printing, offset lithography printing, dry offset lithography printing, flexographic printing, web printing, spray coating, curtain coating, brush coating, slot dye coating or pad printing.

Ink jet printing is particularly preferred when high resolution layers and devices need to be prepared. Selected formulations of the present invention may be applied to prefabricated device substrates by ink jet printing or microdispensing. Preferably industrial piezoelectric print heads such as but not limited to those supplied by Aprion, Hitachi-Koki, InkJet Technology, On Target Technology, Picojet, Spectra, Trident, Xaar may be used to apply the organic semiconductor layer to a substrate. Additionally semi-industrial heads such as those manufactured by Brother, Epson, Konica, Seiko Instruments, Toshiba TEC or single nozzle microdispensers such as those produced by Microdrop and Microfab may be used.

In order to be applied by ink jet printing or microdispensing, the compounds or polymers should be first dissolved in a suitable solvent. Solvents must fulfil the requirements stated above and must not have any detrimental effect on the chosen print head. Additionally, solvents should have boiling points >100°C, preferably >140°C and more preferably >150°C in order to prevent operability problems caused by the solution drying out inside the print head. Apart from the solvents mentioned above, suitable solvents include substituted and non-substituted xylene derivatives, di-C₁₋₂-alkyl formamide, substituted and non-substituted anisoles and other phenol-ether derivatives, substituted heterocycles such as substituted pyridines, pyrazines, pyrimidines, pyrrolidinones, substituted and non-substituted *N,N*-di-C₁₋₂-alkylanilines and other fluorinated or chlorinated aromatics.

A preferred solvent for depositing a compound or polymer according to the present invention by ink jet printing comprises a benzene derivative which has a benzene ring substituted by one or more substituents wherein the total number of carbon atoms among the one or more substituents is at least three. For example, the benzene derivative may be substituted with a propyl group or three methyl groups, in either case there being at least three carbon atoms in total. Such a solvent enables an ink jet fluid to be formed comprising the solvent with the compound or polymer, which reduces or prevents clogging of the jets and separation of the components during spraying. The solvent(s) may include those selected from the following list of examples: dodecylbenzene, 1-methyl-4-tert-butylbenzene, terpineol, limonene, isodurene, terpinolene, cymene, diethylbenzene. The solvent may be a solvent mixture, that is a combination of two or more solvents, each solvent preferably having a boiling point >100°C, more preferably >140°C. Such solvent(s) also enhance film formation in the layer deposited and reduce defects in the layer.

The ink jet fluid (that is a mixture of solvent, binder and semiconducting compound) preferably has a viscosity at 20°C of at least 1 mPa·s. Preferably the ink jet fluid has a viscosity at 20°C of at most 100 mPa·s, more preferably of at most 50 mPa·s and most preferably of at most 30 mPa·s.

The polymer blends and formulations according to the present invention can additionally comprise one or more further components or additives selected, for example, from surface-active compounds, lubricating agents, wetting agents, dispersing agents, hydrophobing agents, adhesive agents, flow improvers, defoaming agents, deaerators, diluents which may be reactive or non-reactive, auxiliaries, colourants, dyes or pigments, sensitizers, stabilizers, nanoparticles or inhibitors.

The invention additionally provides an electronic device comprising a compound, polymer, polymer blend, formulation or organic semiconducting layer according to the present invention. Such devices are OPVs (organic photovoltaic cells), and OPDs (organic photodiodes). Preferred devices are OPDs.

Especially preferred OPV devices are bulk heterojunction (BHJ) OPV devices.

For use in OPV or OPD devices the polymer according to the present invention is preferably used in a formulation that comprises or contains, more preferably consists essentially of, very preferably exclusively of, a p-type (electron donor) semiconductor and an n-type (electron acceptor) semiconductor. The p-type semiconductor is constituted by a polymer according to the present invention.

The present OPV or OPD device may preferably comprise, between the active layer and the first or second electrode, one or more additional buffer layers acting as hole transporting layer and/or electron blocking layer, which comprise a material such as a metal oxide, like for example, ZTO, MoOₓ, NiOₓ, a conjugated polymer electrolyte, like for example PEDOT:PSS, a conjugated polymer, like for example polytriarylamine (PTAA), an organic compound, like for example N,N'-diphenyl-N,N'-bis(1-naphthyl)(1,1'-biphenyl)-4,4'diamine (NPB), N,N'-diphenyl-N,N'-(3-methylphenyl)-1,1'-biphenyl-4,4'-diamine (TPD), or alternatively as hole blocking layer and/or electron transporting layer, which comprise a material such as a metal oxide, like for example, ZnOₓ, TiOₓ, a salt, like for example LiF, NaF, CsF, a conjugated polymer electrolyte, like for example poly[3-(6-trimethylammoniumhexyl)thiophene], poly(9,9-bis(2-ethylhexyl)-fluorene]-*b-*poly[3-(6-trimethylammoniumhexyl)thiophene], or poly[(9,9-bis(3'-(N,N-dimethyl-amino)propyl)-2,7-fluorene)-alt-2,7-(9,9-dioctylfluorene)] or an organic compound, like for example tris(8-quinolinolato)-aluminium(III) (Alq₃), 4,7-diphenyl-1,10-phenanthroline.

In a blend or mixture of a polymer according to the present invention with a fullerene or modified fullerene, the ratio polymer:fullerene is preferably from 5:1 to 1:5 by weight, more preferably from 1:1 to 1:3 by weight, most preferably 1:1 to 1:2 by weight. A polymeric binder may also be included, from 5 to 95% by weight. Examples of binder include polystyrene (PS), polypropylene (PP) and polymethylmethacrylate (PMMA).

To produce thin layers in BHJ OPV devices the compounds, polymers, polymer blends or formulations of the present invention may be deposited by any suitable method. Liquid coating of devices is more desirable than vacuum deposition techniques. Solution deposition methods are especially preferred. The formulations of the present invention enable the use of a number of liquid coating techniques.

Preferred deposition techniques include, without limitation, dip coating, spin coating, ink jet printing, nozzle printing, letter-press printing, screen printing, gravure printing, doctor blade coating, roller printing, reverse-roller printing, offset lithography printing, dry offset lithography printing, flexographic printing, web printing, spray coating, curtain coating, brush coating, slot dye coating or pad printing. For the fabrication of OPV devices and modules area printing method compatible with flexible substrates are preferred, for example slot dye coating, spray coating and the like.

Suitable solutions or formulations containing the blend or mixture of a polymer according to the present invention with a C₆₀ or C₇₀ fullerene or modified fullerene like PCBM must be prepared. In the preparation of formulations, suitable solvent must be selected to ensure full dissolution of both component, p-type and n-type and take into account the boundary conditions (for example rheological properties) introduced by the chosen printing method.

Organic solvents are generally used for this purpose. Typical solvents can be aromatic solvents, halogenated solvents or chlorinated solvents, including chlorinated aromatic solvents. Examples include, but are not limited to chlorobenzene, 1,2-dichlorobenzene, chloroform, 1,2-dichloroethane, dichloromethane, carbon tetrachloride, toluene, cyclohexanone, ethylacetate, tetrahydrofuran, anisole, morpholine, o-xylene, m-xylene, p-xylene, 1,4-dioxane, acetone, methylethylketone, 1,2-dichloroethane, 1,1,1-trichloroethane, 1,1,2,2-tetrachloroethane, ethyl acetate, n-butyl acetate, dimethylformamide, dimethylacetamide, dimethylsulfoxide, tetraline, decaline, indane, methyl benzoate, ethyl benzoate, mesitylene and combinations thereof.

The OPV device can for example be of any type known from the literature (see e.g. Waldauf et al., Appl. Phys. Lett., 2006, 89, 233517).

A first preferred OPV device according to the invention comprises the following layers (in the sequence from bottom to top):
- optionally a substrate,
- a high work function electrode, preferably comprising a metal oxide, like for example ITO, serving as anode,
- an optional conducting polymer layer or hole transport layer, preferably comprising an organic poymer or polymer blend, for example of PEDOT:PSS (poly(3,4-ethylenedioxythiophene): poly(styrene-sulfonate), or TBD (N,N'-dyphenyl-N-N'-bis(3-methylphenyl)-1,1'biphenyl-4,4'-diamine) or NBD (N,N'-dyphenyl-N-N'-bis(1-napthylphenyl)-1,1'biphenyl-4,4'-diamine),
- a layer, also referred to as "active layer", comprising a p-type and an n-type organic semiconductor, which can exist for example as a p-type/n-type bilayer or as distinct p-type and n-type layers, or as blend or p-type and n-type semiconductor, forming a BHJ,
- optionally a layer having electron transport properties, for example comprising LiF,
- a low work function electrode, preferably comprising a metal like for example aluminum, serving as cathode,
wherein at least one of the electrodes, preferably the anode, is transparent to visible light, and
wherein the p-type semiconductor is a polymer according to the present invention.

A second preferred OPV device according to the invention is an inverted OPV device and comprises the following layers (in the sequence from bottom to top):
- optionally a substrate,
- a high work function metal or metal oxide electrode, comprising for example ITO, serving as cathode,
- a layer having hole blocking properties, preferably comprising a metal oxide like TiOₓ or Znₓ,
- an active layer comprising a p-type and an n-type organic semiconductor, situated between the electrodes, which can exist for example as a p-type/n-type bilayer or as distinct p-type and n-type layers, or as blend or p-type and n-type semiconductor, forming a BHJ,
- an optional conducting polymer layer or hole transport layer, preferably comprising an organic polymer or polymer blend, for example of PEDOT:PSS or TBD or NBD,
- an electrode comprising a high work function metal like for example silver, serving as anode,
wherein at least one of the electrodes, preferably the cathode, is transparent to visible light, and
wherein the p-type semiconductor is a polymer according to the present invention.

In the OPV devices of the present invention the p-type and n-type semiconductor materials are preferably selected from the materials, like the polymer/fullerene systems, as described above

When the active layer is deposited on the substrate, it forms a BHJ that phase separates at nanoscale level. For discussion on nanoscale phase separation see Dennler et al, Proceedings of the IEEE, 2005, 93 (8), 1429 or Hoppe et al, Adv. Func. Mater, 2004, 14(10), 1005. An optional annealing step may be then necessary to optimize blend morpohology and consequently OPV device performance.

Another method to optimize device performance is to prepare formulations for the fabrication of OPV(BHJ) devices that may include high boiling point additives to promote phase separation in the right way. 1,8-Octanedithiol, 1,8-diiodooctane, nitrobenzene, chloronaphthalene, and other additives have been used to obtain high-efficiency solar cells. Examples are disclosed in J. Peet, et al, Nat. Mater., 2007, 6, 497 or Fréchet et al. J. Am. Chem. Soc., 2010, 132, 7595-7597.

A further aspect of the invention relates to both the oxidised and reduced form of the compounds according to this invention. Either loss or gain of electrons results in formation of a highly delocalised ionic form, which is of high conductivity. This can occur on exposure to common dopants. Suitable dopants and methods of doping are known to those skilled in the art, e.g. from EP 0 528 662, US 5,198,153 or WO 96/21659.

The doping process typically implies treatment of the semiconductor material with an oxidating or reducing agent in a redox reaction to form delocalised ionic centres in the material, with the corresponding counterions derived from the applied dopants. Suitable doping methods comprise for example exposure to a doping vapor in the atmospheric pressure or at a reduced pressure, electrochemical doping in a solution containing a dopant, bringing a dopant into contact with the semiconductor material to be thermally diffused, and ion-implantantion of the dopant into the semiconductor material.

When electrons are used as carriers, suitable dopants are for example halogens (e.g., I₂, Cl₂, Br₂, ICl, ICl₃, IBr and IF), Lewis acids (e.g., PF₅, AsFs, SbFs, BF₃, BCl₃, SbCl₅, BBr₃ and SO₃), protonic acids, organic acids, or amino acids (e.g., HF, HCI, HNO₃, H₂SO₄, HClO₄, FSO₃H and ClSO₃H), transition metal compounds (e.g., FeCl₃, FeOCI, Fe(ClO₄)₃, Fe(4-CH₃C₆H₄SO₃)₃, TiCl₄, ZrCl₄, HfCl₄, NbF₅, NbCl₅, TaCl₅, MoF₅, MoCl₅, WF₅, WCl₆, UF₆ and LnCl₃ (wherein Ln is a lanthanoid), anions (e.g., Cl⁻, Br, I⁻, I₃⁻, HSO₄⁻, SO₄²⁻, NO₃⁻, ClO₄⁻, BF₄⁻, PF₆⁻, AsF₆⁻, SbF₆⁻, FeCl₄⁻, Fe(CN)₆³⁻, and anions of various sulfonic acids, such as aryl-SO₃⁻). When holes are used as carriers, examples of dopants are cations (e.g., H⁺, Li⁺, Na⁺, K+, Rb⁺ and Cs⁺), alkali metals (e.g., Li, Na, K, Rb, and Cs), alkaline-earth metals (e.g., Ca, Sr, and Ba), O₂, XeOF₄, (NO₂⁺) (SbF₆⁻), (NO₂⁺) (SbCl₆⁻), (NO₂⁺) (BF₄⁻), AgClO₄, H₂IrCl₆, La(NO₃)₃ 6H₂O, FSO₂OOSO₂F, Eu, acetylcholine, R₄N⁺, (R is an alkyl group), R₄P⁺ (R is an alkyl group), R₆As⁺ (R is an alkyl group), and R₃S⁺ (R is an alkyl group).

The present application also relates to the use of polymer particles to adapt, preferably to increase, the viscosity of a composition comprising an organic semiconducting material and a solvent, with said polymer particles, organic semiconducting material and solvent as defined above.

The viscosity data of Table 2 in the following examples clearly illustrate the effect of the addition of the polymer nanoparticles to the formulation. It has been surprisingly found that the viscosity of the resulting formulation can be dramatically increased by the addition of the polymer nanoparticles, preferably in combination with a higher molecular weight semiconductor material. The present application therefore offers a method to influence the viscosity of a formulation over a much wider range of viscosities as generally possible. This in turn renders the formulations more versatile in that they can be used in a wider range of different processes. The compositions of the present application are particularly well suited for coating the active layer in organic electronic devices, such as organic photovoltaic cells, organic photo diode sensors or organic transistors.

### Examples

The following examples are intended to illustrate the advantages of the present invention in a non-limiting way.

For the purposes of the present application DMA is used to denote 3,5-dimethyl anisole.

### Example 1 - Preparation of a polymer nanoparticle dispersion

SPHERO™ cross-linked polystyrene nanoparticles with an average size of 0.45 µm were obtained from Spherotech Inc., Lake Forest, Illinois, USA in form of a 5 % dispersion in de-ionized water with 0.02 % sodium azide added.

10 ml of the above SPHERO™ polymer nanoparticle dispersion were centrifuged for one hour at a speed of 10,000 rpm. Supernatant water was removed and 50 ml ethanol added. The resulting mixture was subjected to three consecutive cycles of 30 min of sonication and subsequent centrifuging. The precipitate was dried under vacuum, 10 ml of 3,5-dimethyl anisole added and the resulting mixture sonicated for 30 min, yielding a dispersion of SPHERO™ polymer nanoparticles in 3,5-dimethyl anisole.

### Example 2 - Preparation of a photoactive formulation

Photoactive formulations were prepared from the dispersion of Example 1, an n-type semiconducting material, a p-type semiconducting material and additional 3,5-dimethyl anisole by adding the respective pre-determined amounts to a vial and stirring at 70°C overnight.

As n-type semiconducting material phenyl-C₆₁-butyric acid (PCBM) methyl ester was used. As p-type semiconducting material a copolymer comprising benzodithiophene units and benzothiadiazole units was used. The p-type semiconducting material of formulations S2 and S3 had a molecular weight of 57 kg/mol (denoted "L-MW" in Table 1), the one of formulations S4 to S8 a molecular weight of 128 kg/mol (denoted "H-MW" in Table 1).

Respective concentrations of the components of the formulations are given in Table 1. The respective viscosities, determined at 25°C using a TA Instruments AR-G2 rheometer, are listed in Table 2, wherein the volume of DMA is the total volume of DMA in the respective formulation.

**Table 1**

| Formulation | Polymer nanoparticles | PCBM | P-type semiconductor | DMA |
|---|---|---|---|---|
| | [mg] | [mg] | [mg] | [ml] |
| S1 | 25 | 0 | 0 | 1 |
| S2 | 0 | 15 | 10 (L-MW) | 1 |
| S3 | 25 | 15 | 10 (L-MW) | 1 |
| S4 | 25 | 15 | 10 (H-MW) | 1 |
| S5 | 0 | 15 | 10 (H-MW) | 1 |
| S6 | 15 | 15 | 10 (H-MW) | 1 |
| S7 | 15 | 20 | 10 (H-MW) | 1 |
| S8 | 15 | 30 | 10 (H-MW) | 1 |

**Table 2**

| Formulation | Viscosity at 500 rpm |
|---|---|
| | [cP] |
| S1 | 2.8 |
| S2 | 1.8 |
| S3 | 8.8 |
| S4 | 37 |
| S5 | 2.7 |
| S6 | 11 |
| S7 | 12 |
| S8 | 13 |

The influence of polymer molecular weight can be seen by comparing the viscosities of formulations S2 and S5 as well as S3 and S4. The viscosity of the formulation is generally found to be proportional to the molecular weight of the polymer, here for example of the p-type semiconducting material, to the power of 0.5 to 0.7. However, from a synthetic point of view the maximum molecular weight of such a polymer is limited and cannot be indefinitely increased, also for reasons of solubility of the polymer in the formulation. This limitation in molecular weight poses severe limitations on the potential use of such polymers in a number of specific deposition methods, such as for example screen printing.

It has now been found that the addition of the present polymer nanoparticles has a surprisingly strong impact on the viscosity of a formulation. The comparison of the viscosity data of Table 2 for formulations S2 and S3 as well as for S5 and S6, respectively, clearly puts this effect into evidence. One can also see that the effect is even more pronounced when the molecular weight of the polymer is increased.

### Example 3 - Device fabrication

The formulations of Example 2 were used to produce organic photodetector devices with inverted structure: ITO/ ETL/Active layer/ HTL/ Ag, with ETL denoting electron transport layer, HTL denoting electron transport layer and ITO denoting indium tin oxide.

As substrates pre-patterned ITO substrates (6 round ITO dots with a diameter of 5 mm, with each dot being connected by a narrow strip of ITO to a pad on the edge of the substrate for diode connection) were used. These substrates were cleaned by placing them inside a Teflon holder in a beaker and then sonicating at 70°C for 10 min each successively in acetone, isopropanol and de-ionized water. They were then rinsed in a spin rinse dryer and eventually exposed to UV light and ozone for 10 min.

The ETL was prepared by spin coating
(i) a blend of PVP and 1 wt% Cs₂CO₃ in methanol, or
(ii) ZnO nanoparticles dispersed in an alcohol solvent
at 2000 rpm for 1 min, followed by drying on a hot plate for 10 min at a temperature of 100°C to 140°C.

For the active layer the formulations of Example 2 were deposited onto the previously formed ETL by using a K101 Control Coater System from RK. Stage temperature was set to 70°C, the gap between blade and substrate to 2 - 15 µm and speed to 2 - 8 m min⁻¹. The active layer was then annealed for 10 min at 100°C.

The HTL was formed by depositing MoO₃ onto the previously formed active layer using an electron beam evaporation method using a Lesker evaporator at a pressure of 10⁻⁷ Torr and an evaporation rate of 0.1 Å s⁻¹ to a thickness of 5 to 30 nm.

Finally as top electrode Ag was deposited by using a thermal evaporation method through a shadow mask to a thickness of 40 to 80 nm.

It is noted that due to the fabrication method film thicknesses may vary greatly depending upon the viscosity of the formulation. For example, total film thickness for formulation S3 was around 600 nm while the thickness for formulation S4 was around 1500 nm.

### IV curves and external quantum efficiency (EQE)

IV curves of the so-produced devices were measured using a Keithley 4200 system under light and dark conditions. Light source was a LED emitting at 580 nm and a power of ca. 0.5 mW cm⁻².

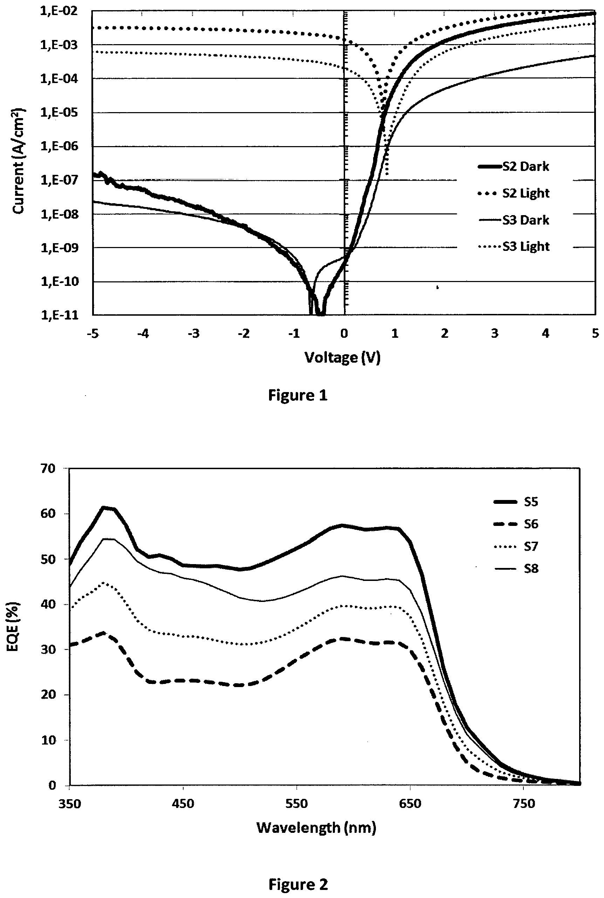

IV curves and external quantum efficiency (EQE) of devices prepared using formulations S2 and S3 for the respective active layers are shown in **Figure 1****.**

Under dark conditions the current intensities of the reference device prepared using formulation S2 and of the device prepared using formulation S3 are quite similar. This suggests that the nanoparticles do not have a negative influence, for example by introducing pinholes or leakage phenomena. However, the photocurrent of devices prepared using formulation S3 has significantly dropped in comparison to reference devices prepared using formulation S2. Without wishing to be bound by theory, it is believed that this drop may be caused by a hydrophilic particle surface attracting PCBM, potentially acting as insulator or charge transfer barrier and/or resulting in a reduced ratio of PCBM to p-type polymer in the active layer.

To test this hypothesis, devices with an increased ratio of PCBM were prepared. **Figure 2** shows the external quantum efficiency of devices prepared using formulations S5, S6, S7 and S8. The data shows that the drop in EQE found for the device produced using formulation S3 can be compensated by adding PCBM to the formulation. The reference device prepared using formulation S5 has an EQE of around 58 % at 650 nm. With the addition of SPHERO™ nanoparticles (formulation S6) this value goes down to about 30 %. By adding further PCBM to the formulation, the EQE can again be increased and reaches for example 45 % at twice the concentration of PCBM (formulation S8).

### Stability

In order to test the stability of the devices produced in accordance with the present application, a device prepared using formulation S3 and a reference device prepared using formulation S2 were stored in air in a non-sealed plastic box for more than one month. IV curves were taken at 0 days, 14 days and 35 days from producing the devices.

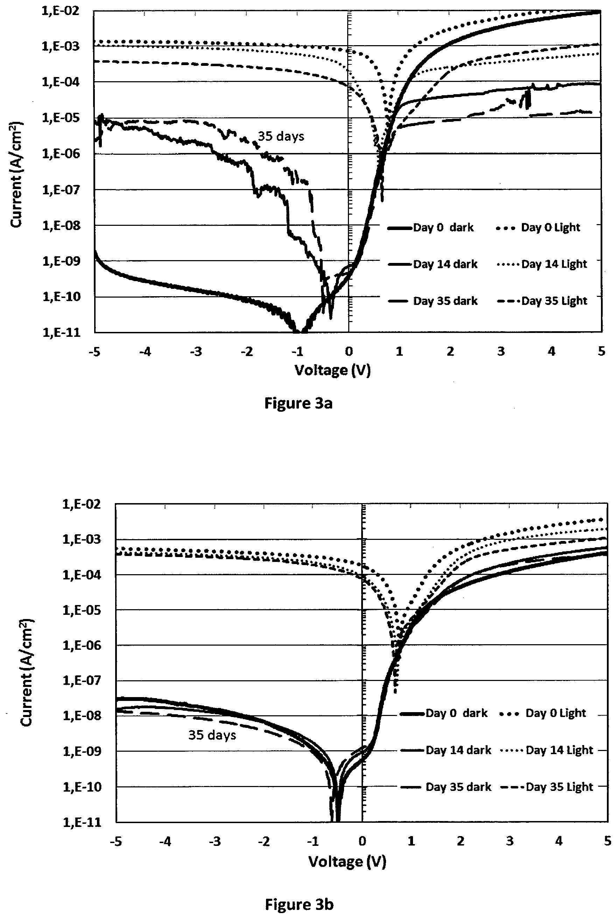

As can be seen in **Figure 3a**, the dark current of the reference device producing using formulation S2 increased by four orders of magnitude, while the photocurrent at zero bias dropped significantly to about 30 to 50 % of the original value.

Very surprisingly, as shown in **Figure 3b** the device prepared using formulation S3, i.e. in accordance with the present invention, did not change significantly during the test period and basically maintained the same performance throughout the test period.

The present examples clearly show the advantages of the present invention. Generally stated, devices produced in accordance with the present application are characterized by an increased stability, i.e. they maintain performance over a longer period of time, than do conventional devices.

The viscosity data of Table 2 clearly illustrate the effect of the addition of the polymer nanoparticles to the formulation. It has been surprisingly found that the viscosity of the resulting formulation can be dramatically increased by the addition of the polymer nanoparticles, preferably in combination with a higher molecular weight semiconductor material. The present application therefore offers a method to influence the viscosity of a formulation over a much wider range of viscosities as generally possible. This in turn renders the formulations more versatile in that they can be used in a wider range of different processes.

Additionally, the formulations of the present application allow to broaden the viscosities of formulations that are useful in the preparation of organic electronic devices. This, in fact, also allows the use of so far not readily useable methods of producing such electronic devices, for example screen printing.

In consequence, the present invention will prove particularly useful in the furthering of high-throughput production methods and ultimately allow for cost reductions in the production processes.

## Claims

1. Device comprising a layer that in turn comprises an organic semiconducting material and a polymer in form of particles, wherein said particles have a diameter of at most 2 µm,
wherein the device is an organic photovoltaic device or an organic photodetector device and
**characterized in that** the polymer is polystyrene.

2. Device according to claim 1, wherein the particles have a diameter of at least 10 nm.

3. Device according to any one or more of the preceding claims, wherein said particles have a diameter of at most 1.5 µm.

4. Device according to any one or more of the preceding claims, wherein said particles have a diameter of at least 10 nm.

5. Device according to any one or more of the preceding claims, wherein said polymer comprises cross-linking.

6. Device according to any one or more of the preceding claims, wherein the device is an organic photodetector device.

7. Process of preparing a device according to any of the preceding claims, said process comprising the steps of
(a) providing a composition comprising an organic semiconducting material, a solvent and a polymer in form of particles,
(b) depositing said composition onto a substrate, and
(c) essentially removing said solvent,
wherein said particles have a diameter of at most 2 µm, and said device is an organic photovoltaic device or an organic photodetector device.

8. Process according to claim 7, wherein step (b) is performed by a printing method.

9. Process according to claim 7 or claim 8, wherein step (b) is performed by screen printing, gravure printing or flexographic printing.

## Patentansprüche

1. Vorrichtung enthaltend eine Schicht, die wiederum ein organisches Halbleitermaterial und ein Polymer in Teilchenform enthält, wobei die Teilchen einen Durchmesser von höchstens 2 µm aufweisen,
wobei es sich bei der Vorrichtung um eine organische Photovoltaikvorrichtung oder eine organische Photodetektorvorrichtung handelt und
**dadurch gekennzeichnet, dass** es sich bei dem Polymer um Polystyrol handelt.

2. Vorrichtung nach Anspruch 1, wobei die Teilchen einen Durchmesser von mindestens 10 nm aufweisen.

3. Vorrichtung nach einem oder mehreren beliebigen der vorhergehenden Ansprüche, wobei die Teilchen einen Durchmesser von höchstens 1,5 µm aufweisen.

4. Vorrichtung nach einem oder mehreren beliebigen der vorhergehenden Ansprüche, wobei die Teilchen einen Durchmesser von mindestens 10 nm aufweisen.

5. Vorrichtung nach einem oder mehreren beliebigen der vorhergehenden Ansprüche, wobei das Polymer Vernetzung enthält.

6. Vorrichtung nach einem oder mehreren beliebigen der vorhergehenden Ansprüche, wobei es sich bei der Vorrichtung um eine organische Photodetektorvorrichtung handelt.

7. Verfahren zur Herstellung einer Vorrichtung nach beliebigen der vorhergehenden Ansprüche, welches die Schritte
(a) Bereitstellen einer Zusammensetzung enthaltend ein organisches Halbleitermaterial, ein Lösungsmittel und ein Polymer in Teilchenform,
(b) Abscheiden der Zusammensetzung auf ein Substrat und
(c) in Wesentlichen Entfernen des Lösungsmittels
umfasst, wobei die Teilchen einen Durchmesser von höchstens 2 µm aufweisen und es sich bei der Vorrichtung um eine organische Photovoltaikvorrichtung oder eine organische Photodetektorvorrichtung handelt.

8. Verfahren nach Anspruch 7, wobei Schritt (b) durch ein Druckverfahren durchgeführt wird.

9. Verfahren nach Anspruch 7 oder Anspruch 8, wobei Schritt (b) durch Siebdruck, Tiefdruck oder Flexodruck durchgeführt wird.

## Revendications

1. Dispositif comprenant une couche qui à son tour comprend un matériau de semiconduction organique et un polymère sous la forme de particules ; dans lequel :
lesdites particules présentent un diamètre d'au plus 2 µm ; et dans lequel :
le dispositif est un dispositif photovoltaïque organique ou un dispositif de photodétecteur organique ; et
**caractérisé en ce que** le polymère est du polystyrène.

2. Dispositif selon la revendication 1, dans lequel les particules présentent un diamètre d'au moins 10 nm.

3. Dispositif selon l'une quelconque ou plusieurs quelconques des revendications qui précèdent, dans lequel lesdites particules présentent un diamètre d'au plus 1,5 µm.

4. Dispositif selon l'une quelconque ou plusieurs quelconques des revendications qui précèdent, dans lequel lesdites particules présentent un diamètre d'au moins 10 nm.

5. Dispositif selon l'une quelconque ou plusieurs quelconques des revendications qui précèdent, dans lequel ledit polymère comprend une réticulation.

6. Dispositif selon l'une quelconque ou plusieurs quelconques des revendications qui précèdent, dans lequel le dispositif est un dispositif de photodétecteur organique.

7. Procédé de préparation d'un dispositif selon l'une quelconque des revendications qui précèdent, ledit procédé comprenant les étapes constituées par :
(a) la fourniture d'une composition qui comprend un matériau de semiconduction organique, un solvant et un polymère sous la forme de particules ;
(b) le dépôt de ladite composition sur un substrat ; et
(c) de façon essentielle, l'évacuation dudit solvant ; dans lequel :
lesdites particules présentent un diamètre d'au plus 2 µm, et ledit dispositif est un dispositif photovoltaïque organique ou un dispositif de photodétecteur organique.

8. Procédé selon la revendication 7, dans lequel l'étape (b) est réalisée au moyen d'un procédé d'impression.

9. Procédé selon la revendication 7 ou la revendication 8, dans lequel l'étape (b) est réalisée au moyen d'une impression par sérigraphie, d'une impression par gravure ou d'une impression flexographique.
